# EUROPEAN PATENT SPECIFICATION

(11) **EP 1 276 555 B1**
(45) Date of publication and mention of the grant of the patent: **17.11.2004**
(21) Application number: 01969031.2
(22) Date of filing: 18.04.2001
(51) Int. Cl.: B01J 19/00

(54) **A METHOD OF FABRICATING CODED PARTICLES**
VERFAHREN ZUR HERSTELLUNG VON KODIERTEN TEILCHEN
PROCEDE DE FABRICATION DE PARTICULES CODEES

(30) Priority: 19.04.2000 GB 0009719; 08.12.2000 WO PCT/GB00/04696
(43) Date of publication of application: 22.01.2003
(73) Proprietor: 3D Molecular Sciences Limited, Harston, Cambridgeshire CB2 5GG (GB)
(72) Inventor: SOM, Amit Kumar, Scientific Generics Limited, Harston, Cambridgeshire CB2 5NH (GB); SKINNER, Nigel Guy, Scientific Generics Limited, Harston, Cambridgeshire CB2 5NH (GB); WATSON, Susan Louise, Scientific Generics Limited, Harston, Cambridgeshire CB2 5NH (GB)
(74) Representative: Davies, Jonathan Mark
(86) International application number: PCT/GB2001/001779
(87) International publication number: WO 2001/078889

(56) References cited:
- GB-A- 2 306 484

## Description

The present invention relates to a method of fabricating coded particles. One of many uses for such particles is in identifying the sequence of oligomers.

In a wide range of biochemical and chemical procedures there is a requirement for identifying the sequence of an unknown oligomer of known (relatively short) length. The oligomer may be formed from nucleotides (RNA or DNA), amino acids (peptides and proteins), sugars or any other oligomerisable chemical compound. The oligomer may even be an antibody/antigen complex used in, for example, immunoassays.

With regard to oligonucleotides, one approach is to place the unknown (target) strand in the presence of all possible (analyte) strands of some shorter length. A small number of complementary analyte strands will bind to the target strand and this binding event may be identified by any suitable means, for example fluorescence, electrochemiluminescence, chemiluminenscence, biochemiluminescence or phosphorescence. In an existing technology, the analyte strands are spatially distributed on a surface. The sequence of the analyte strand is encoded in its location on the surface. The identity of the target strand can, therefore, be deduced from the physical location of the binding event in relation to the surface.

An alternative technology is based on small, physically differentiable beads. At least one analyte strand of known sequence is attached to a bead in such a way that all of the attached strands have the identical sequence. In this way, the sequence of a particular strand may be identifiable from the particular bead to which the strand is attached. The beads are then exposed to the target strand and binding between the target strand and any analyte strands may be detected using any suitable detection means, for example fluorescence. The beads upon which a binding event occurred may then be separated from the bulk of the beads and the sequence of the target strand deduced from the sequence of the bound analyte strand that is identifiable by a number of means.

A method of fabricating machine-readable beads is described in GB-A-2334347 and GB-A 2 306 484. The application describes a method of fabricating coded particles comprising the steps of:
- coating a face of a wafer of silicon or a similar crystalline material or inert metal or metal alloy with a photoresist polymer;
- exposing the coated face of the wafer to UV radiation through a photolithographic mask, the mask defining the particle size and/or the position of code sites on the particle;
- dissolving or otherwise removing either the UV-exposed or the UV-unexposed areas of the photoresist polymer;
- etching the exposed areas of the wafer, from which the photoresist polymer has been removed, using an appropriate etching agent; and
- liberating the particles.
One difficulty with both of these systems is the fabrication of analyte strands in such a manner that they can subsequently be identified.

The application of such machine readable beads to the life sciences (combinatorial chemistry, proteomics, genomics, pharmacogenomics) requires the further derivitisation of suitable ligands (antibodies, antigens, oligonucleotides, etc.), often along with the addition of label chemistries (e.g. fluorophores, ruthenium salts). Polymers provide a desirable substrate for many such applications and the beads enhance the signal-to-noise ratio (larger surface area providing means of binding more molecules). One of the drawbacks, particularly for highly multiplexed assays (for example, DNA sequencing) where it is necessary to derivatise anywhere between 1 and more than 60,000 different molecules, is the coating of the beads. For example, to have every single possible combination of the 4 nucleotide bases represented in an oligonucleotide sequence of 8 nucleotides in length (8 mer) one would require 65,536 different beads to represent every number (4^{^}8=65536). There are two issues here:
- handling a large number of small (less than 100 micron diameter) beads before, during and after the coating procedure;
- for DNA sequencing, being able to build-up the required sequences.

A combinatorial synthesis method has been developed in order to solve this problem. This approach involves the selective masking/demasking of sequences and the use of photolabile groups for the attachment of bases. This is a complex and costly procedure which is not easily customisable due to high non-recoverable engineering costs (masks, process optimisation) as well as suffering from low signal-to-noise ratio and poor diffusional mixing due to the planar topology presented to analyte containing sample.

WO97/15390 discloses the concept of making shape encoded microparticles from polymer but offers no viable method for doing this.

The present invention seeks to overcome these and other drawbacks or disadvantages with conventional methods. Accordingly, in the first aspect of the present invention, there is provided a method of fabricating coded particles comprising:
providing a sheet of polymeric material on a substrate;
delineating the sheet into a plurality of particles without destroying the integrity of the substrate;
machine-readably encoding the particles; and
removing the particles from the substrate.

Fabrication of machine readable polymer beads is attractive for several reasons. Firstly, it provides a lower cost-manufacturing route than for silicon beads. Secondly, polymers (in particular: polystyrene, polyimide and polycarbonate) are preferred substrates for subsequent derivitisation with a wide variety of ligands.

In the second aspect of the second invention we provide a method of fabricating coded particles in a modified micro-titre plate format.

The particles may be removed from the substrate by various methods as further described below. In some of these methods the substrate is a sacrificial substrate which is destroyed to remove the particles therefrom.

When chemical library members are placed on the beads or particles prior to removal from a sacrificial substrate, the method used to release the beads and destroy the sacrificial layer must not, damage the attached molecules. This is particularly true of biological molecules and applies to both formats: wafer and mircrotitre plate. In both cases, the beads may be released by destroying the integrity of the sacrificial substrate. Where there is a layer of SPLOR30B (as described below), one way of doing this is to use the proprietary developer solution developed for SPLOR30B which happens to be alkaline.

This alkaline material may not be suitable for all biological molecules and hence other sacrificial layers may be used to allow biological molecules to be attached to the substrate prior to release of the individual bead structure.

The sacrificial layer may be a polyolefin (e.g. polyethylene) or soluble in solvents or water. It may also be sensitive to temperature e.g. gelatine or be pH sensitive.

Whether the beads are on the wafer or on the microtitre substrate, they may be removed using mechanical energy, e.g. a directed beam of ultrasonic energy to gently mechanically agitate or cavitate the beads off the substrate. The coupling medium for the ultrasonic energy may be a biocompatible fluid such as water or a solvent.

The sacrificial layer may be a thixotropic material, i.e. it is stiff in equilibrium and holds the beads in place. When ultrasonic shear waves are directed on to this layer, the material loses its stiffness and starts to flow thus permitting the beads to be released.

The sacrificial layer may have properties such that at room temperature, the layer holds the beads in place. When the wafer is frozen, e.g. using a jet of liquid nitrogen the layer freezes and becomes so brittle that the beads are released.

The sacrificial layer may be sensitive to radiation, e.g. UV and clearly this functions in substrates that are transparent to UV. In the case of water format, although silicon has been used as a substrate in an example below, any similar flat substrate, e.g. a flat quartz wafer which permits the UV energy to pass through to the film/bead interface may be used.

Another technique for attaching and releasing beads involves the use of individually addressable electrodes either on a solid wafer or a flexible circuit material, e.g. polyimide supported on a flat, solid structure. The beads are fabricated on top of the electrodes and are kept attached to the substrate via electrostatic attraction.

Instead of simple, flat electrodes, the idea above may be extended to include MEMS (micro-electro-mechanical) cantilevers at the electrode locations that lift the beads off the substrate and break the bridges.

The beads may be fabricated with thin bridges between them (much like the way plastics injection moulded parts are attached to sprues). The bridges may sit on top of pillars of GMS (Giant Magneto-Strictive) material. When activated, the columns of GMS material break through the bridges and free the beads. The thin bridges may be destroyed in a variety of ways - the particles could all be linked in such a way that pulling on one end of the sprue "unzips" all the beads into suspension. The bridges may also be destroyed by laser cutting by say, a Nd:YAG or carbon dioxide laser.

An SU-8 or other polymer resist may be spun on to a wafer with holes in it that match up to the size of the beads. This ensures that once the beads are fabricated, they are sitting on top of a hole. When it is required to release the beads, a thin pin pushes the bead off the wafer, or a jet of air blows the bead off the substrate into the suspending medium. The surface tension of the liquid polymer is selected such that it does not run down the holes.

The beads could be rendered magnetic, either by the addition of magnetic particles with the resist or a suitable coating. Once the beads are released, they may be isolated and collected through the influence of an external magnetic field. This benefits the handling of the beads.

A scintillant e.g. fluoride may be added to the bead during or post delineation. Binding events between radioactive labelled ligands in solution and the scintillating material are detected by the detection of flashes of light.

The particles are preferably microparticles having a maximum dimension of 1 mm or less, preferably 500 µm or less, more preferably 250 µm or less. In a second and optionally in a third dimension such microparticles preferably are of 100 µm or less, more preferably 50 µm or less, e.g. 25 µm or less.

The particles may be of any shape, for example, plate or disc shaped, but bar or rod like particles are preferred.

To provide room for markings which as a binary code are capable of differently encoding at least 32,000 different particles at a pitch of say 20 µm per mark, it is preferred that the particles have as their largest dimension a size of at least 50 µm, more preferably at least 100 µm. Particles within the size range of 100 µm to 250 µm are therefore preferred. A library of particles need not however contain as many as 32,000 different encoded particles and so particles capable of bearing fewer marker coding elements are still useful. For instance, a library of say 4,000 particles could be coded by only 12 coding elements.

Markings may be formed along at least two sides of each particle.

The particles may be morphologically encoded during the delineation process so that as the overall shape of the particles is defined, so are patterns of 3-dimensional features that provide each particle with its machine readable code.

Alternatively, the particles may be encoded, whether morphologically or otherwise after the delineation of their overall shape but before separation from the substrate.

Non-morphological methods of encoding include selective area bleaching, or the application of inks, paints or dyes which may be monochromatic or multi-coloured or, fluorescent or phosphorescent.

The substrate on which the particles are formed by the delineation process may be a disposable member such as a wafer that is discarded when the particles have been removed from it or it may be a member that forms a structural part of an apparatus in which the particles are subsequently used such as a base plate of a microtitre plate as described in more detail below.

In a preferred practice of the invention, the substrate comprises a base layer and a sacrificial layer on which the sheet of polymeric material for delineation into the particle is carried. The particles are then released by destruction of the adhesion of the particles to the sacrificial layer. This may be such that it is caused to release the particles by UV or other radiation or by other means such as solvent dissolution.

The particles are preferably formed in a photoresist polymer and are delineated therein by applying light via a mask defining the edge contours of the particles. Alternatively, they may be delineated by laser machining.

The coding applied to the microparticles may consist of a sequence of binary features, e.g. along edges of the particles. Each particle may be provided with one or more coding features serving as a reading sense identifier, i.e. indicating the direction in which the sequence of binary features is to be read.

Alternatively, the sequence of binary features may be such that no error in particle identification is introduced in whichever direction the sequence is read. This may be achieved by using only sequences that when read backwards do not match the sequence of any other particle read forwards. Thus by way of example, if one bead has the sequence 11101, there will be no bead with the sequence 10111. If desired, the beads of reversed sequence (i.e. 10111 in this example) can be present and the reader used for reading the sequences can be programmed to regard them as the same.

Optionally, the bead coding is subject to a parity rule to help eliminate misreads of the code. Thus, the coding may be such that all the codes have an even number of 1's. In alternative parity coded schemes, all the codes have an odd number of 1's, or an even or odd number of 0's. This will mean that if one bit is misread, the result will be a nonsense code and the reading can be discarded.

The encoded particles may be used for various purposes, not limited to use in combinatorial chemistry related applications. Thus, for instance they may be used to provide a traceable marking code by incorporation into goods of many kinds. Particles bearing a particular code may be put into paint applied to an article needing to be made traceable, such as an automobile or other high value item. They may be incorporated into batches of material such as oils, lubricating oils, automatic gearbox lubricants, hydraulic fluids, or chemicals to act as batch number records. The codes on the particles may encode date information, such as date of manufacture or scheduled replacement date.

They may also of course be used as substrates in forming a combinatorial chemical library in which a large number of chemically distinct materials are placed on respective particles or portions of particles. These may be oligomeric compounds differing one from another in sequences of monomer units, such as nucleic acids or their analogues (including DNA, RNA, PNA and other modified backbone nucleic acid analogues or hybrids thereof), proteins, polypeptides or peptides, and oligosaccharides.

In general, the compounds of the library may be either synthesised first and then bound to their particles or else may be synthesised stepwise on the particles. In either method, during the attachment of the compounds the particles may be still attached to the substrate on which they were delineated or may have been separated therefrom.

Generally, in a chemical library, it is intended that each particle bearing a particular code should bear a known one of a library of chemical compounds.

Especially where the number of chemical entities in the library is large and even where the particles are small, it may be that the volume taken up by the entire library of particles is undesirably large for ease of handling. In principle, the volume of particle material used could be reduced by making each particle smaller. However, it may not be desirable to reduce the size of the particles any further for various reasons including difficulty that may result in identifying the particles.

Accordingly, particles according to this invention may be employed in a chemical library comprising particles each having at least a first zone and a second zone, each said zone having thereon a respective chemical member of said library, each particle having markings serving to identify the particle and serving to identify said zones of the particle, and thereby to identify the chemical member of the library on any selected zone.

By using each particle for more than one chemical entity within the library but marking the particle so that each chemical entity can be separately identified according to its readable position on the particle, the number of particles needed for a library containing a particular number of chemical entities can be at least halved.

Alternatively, for a given number of particles and a given number of chemical library members supported thereon, the number of physical locations within the particle library at which any particular chemical member can be encountered can be increased. For instance, if a library in accordance with GB-A-2334347 consists of n particles bearing n compounds (one compound per particle), each compound can only be met with at one location within the mass of particles constituting the library. However, if in accordance with the present invention two compounds are present on each particle, without increasing the amount of particle material or the amount of each chemical compound in the library, it becomes possible to meet with each compound at two distinct locations. Thus, the time needed for reaction with the library may be reduced.

In principle, any shape of particle may be used. For instance the particle may be disc shaped with the zones occupied by the respective chemical library members being sector shaped and there being notches or other similar marks at one or more positions around the periphery to mark the identity of each zone. One such peripheral mark will be sufficient no matter how many sectors may be used, as any sector may be located with respect to a single mark according to its angular position with respect thereto.

Preferably however, each particle is of rod-like or bar-like shape having a first end and a second end with said first zone being disposed extending from a location at or near said first end and said second zone being disposed extending from a location at or near said second end.

Each particle may then have markings serving to identify the particle and an end marker serving to identify the first end or the second end of the particle.

The markings may be formed by shapes such as pits, grooves, notches or bumps. They may also be formed as fluorescent, or coloured or monochrome markings such as bars or spots which may be applied as surface markings, e.g. by printing.

The invention includes a method of fabricating a chemical library, comprising providing a sheet of substrate material bearing delineated attached particles as described above, (a) forming deposits of selected chemical library members at known respective spatial zones on the surface of said particles on the substrate material such that each particle includes at least two of said spatial zones each bearing a different one of said chemical library members, each particle being marked with a code identifying the particle and showing the orientation of said particle with respect to said zones such as to enable each said zone to be separately identified.

The term "chemical library" is to include "biological libraries".

Depending on the method of particle delineation however, the deposition of the chemical members of the library may precede or follow the formation of the particle identifying marks.

The chemical members of the library may be oligomeric compounds such as oligonucleotides or peptides in which monomer units selected from a limited range of chemically related compounds are arranged in a sequence characterising the oligomer. They may be non-oligomeric compounds, possibly being related to other members of the library by some common structure or actual or potential property. The compounds may be of complex structure, e.g. may be antibodies or other biomolecules.

The compounds of the library may be pre-synthesised and then placed on the particles or they may be synthesised on the particle surface. The compounds may be chemically bound to the surface of the particles or may be physically adsorbed thereon. The particles may be porous and the compounds of the library may be present within the pores of such a structure although it is preferred that the compounds be on the surface of the particle.

The beads may be of any suitable shape. Preferably, the beads are designed to be thin, typically 25 µm, rectangular shapes with typical lengths of 250 µm and widths of 40 µm.

Once the oligomers or other compounds have been applied to the beads, individual groups of beads can be released and processed e.g. using flow cytometry. With rectangular beads, the long aspect ratio lends itself easily to good mixing within the flow cell, thereby promoting effective binding of the bases of an analyte oligonucleotide onto a complementary target sequence.

Each bead may have features defined around its periphery to give it a unique code. The structural embodiment discussed below is designed to be compatible with current micro-titre plates having 96-wells although the techniques mentioned are equally applicable to larger well sizes. At such dimensions, each 3.5 mm-square well could easily contain an array of 100 by 40 (or 4000) beads. The total number of beads defined within a commercially available 96-well structure would then be in the region of 384,000.

By way of illustration, a 250 µm bead may have its upper surface demarcated into two zones, one bearing a first chemical library member ('Biomolecule 1') and the other bearing a second chemical library member ('Biomolecule 2'). One end of the particle may be provided with a T shaped head having a longer stem than a similar formation at the other end, so that the ends are distinguishable. The presence of the library member can itself serve as a marker identifying which is the upper face, to remove ambiguity as to which long edge of the particle is which. Alternatively, a further code marker may be provided serving to identify one long edge of the particle.

After exposure to a test compound which may bind to or react with a compatible compound on a particular bead in a library of such beads, the beads may be screened to identify on which bead and which end of the bead the binding or other reaction has occurred. This may be done by removing the beads from the well and passing them through a suitable flow system to a detector at which they are inspected one at a time. When the appropriate reaction is detected the bead code is read to identify the reacting library compound.

Optionally, each particle in a library of particles whether for use or otherwise produced by a method according to the invention, may comprise a fluorescent material which has been selectively bleached at selected locations to define markings constituting said machine readable code.

The fluorescent material may be a polymer constituting the particles or it may be a layer of material applied to such a polymer. It may be bleached locally by the application of a sufficient intensity of light energy, e.g. from a laser. A pattern of bleached spots or bars may be formed constituting a binary code. Alternatively, the entire area of the particle may be bleached except for a pattern of spots or bars constituting a binary code.

The laser bleaching operation may be conducted in place of the laser cutting or machining operation described herein, whilst the particles are retained on a substrate by a photo-activated or solvent activated release polymer layer. The divisions between the particles may be made by laser cutting or by photo-lithography. For instance, a mask defining a multitude of micro-particles may be used for exposing a photo-lithographic photo-resist polymer layer supported on a substrate by a photo-actuable polymer release material. The photo-resist may then be developed with a solvent to produce channels therethrough demarcating releasable particles as described above. These may be bleached to form code marks using a laser or other light source, and optionally a chemical library may be applied and the particles may then be released. The released particles may be further processed by any of the methods described herein.

If desired, the particles may each have at least a first zone and a second zone, each said zone having thereon a respective chemical member of said library, each particle having markings service to identify the particle and serving to identify said zones of the particle, and thereby to identify the chemical member of the library on any selected zone.

In principle, any shape of particle may be used. For instance the particle may be disc shaped with bleached marks being encoded at one or more positions around the periphery.

Preferably however, each particle is of rod-like or bar-like shape having bleached code marks formed along each long edge.

Each particle may have markings serving to identify the particle and an end marker or markers serving to identify a first end or the second end of the particle.

The particles are preferably of a size as described herein.

Markings may be formed along at least two sides of each particle.

The deposition of the chemical members of a library may precede or follow the formation of the particle identifying marks and the division of a continuous sheet into separable particles.

The chemical members of the library may be as described above.

The compounds of the library may be pre-synthesised and then placed on the particles or they may be synthesised on the particle surface. The compounds may be chemically bound to the surface of the particles or may be physically adsorbed thereon. The particles may be porous and the compounds of the library may be present within the pores of such a structure although it is preferred that the compounds be on the surface of the particle.

Chemical libraries made according to the invention may be employed in any of the several fields in which chemical libraries have been used or proposed for use in the past including drug discovery assays, DNA sequencing, immunoassays, and combinatorial chemistry.

There are three main routes by which one may attach chemical molecules to the particles or beads. Such molecules include DNA, RNA, PNA, antibodies, antigens, proteins, peptides, ligands, viral particles, phages, cells, chemical compounds, etc. The molecules may be attached on to the beads whilst they are still on the substrate or the attachment may be made after the beads are released. Either way, the materials and processes used to fabricate the beads are desirably compatible with at least one or more preferably all three routes. The three routes are now further described.

In a first route, isolated or pre-synthesised biomolecules are attached directly on to the discrete polymer beads. During the process of attachment, the beads are still on the wafer. After attachment, the beads are released. In a second route, the beads are released from the wafer and stored in separate vessels such that the codes are sequential. Each vessel contains a plurality of beads of the same code. A pre-made oligomer of choice is then bound directly to the bead. Beads from different vessels with different oligomers are then mixed for downstream analysis. In a third method, the beads are released from the substrate into a carrier liquid and are mixed with the chemical building blocks sequentially. Alternatively, the beads are still on the substrate and oligomers are built-up on the beads sequentially and in a stepwise manner. The advantages of this route are: less handling, direct building of different molecules across one substrate and the provision of a multitude of oligomers in relatively few steps.

Four preferred methods of reading codes on particles or beads are as follows:

The output of a laser beam of suitable wavelength is passed through the optical elements that transform the beam into a thin fan-shaped beam. The notches in the bead flowing through the flow cell obstruct the beam. To detect the forward-scattered energy, a sensor may be situated in line with the incident energy and beyond the bead. The output of this sensor varies according to the amount of energy falling on it. In the case of the forward-scattered energy, the notches prevent energy from reaching the detector and the gaps between the notches permit the energy to reach the detector. Either the forward or side scattered signals, or a combination of these signals may be used to deduce the code on the bead.

In another embodiment, rectangular polymer beads may be fabricated with metallic stripes forming the code. Typical metals that may be used are nickel-chrome, titanium and gold. When the beads are used in conjunction with the system above, the laser light is strongly absorbed in non-metallic regions and strongly reflected in the metallic regions. The absorbed or reflected output is representative of the codes.

In a second method, a high-speed imaging camera captures the entire 2D image of the bead. The code on the bead is deduced by subjecting the captured 2D image to commercially available image analysis software. One alternate method is to take advantage of the fact that the bead is flowing past the stationary camera and to capture 1D line scans at high speed. A complete 2D pattern is thus built-up by adding a series of these 1D line scans and analysed as before.

In a third method, multiple image analysis is used. This is relevant particularly for the microtitre plate format. Whilst the beads are within the wells, there is a need to image multiple beads to give a snapshot of the well and analyse the images off-line.

In a fourth method, one uses the natural fluorescence of the bead. Polymer beads may be made that fluoresce when light of a certain wavelength is incident upon them and in the system outlined above in accordance with the first reading method, this wavelength is that of the incident laser. This property may be used to read the codes on the beads by using fluorescence detectors. As described in more detail below, instead of encoding by forming notches around the periphery of a bead one may scribe the same code on a bead with a simple rectangular periphery by taking advantage of either the inherent fluorescence of the bead or the fluorescence of another material deposited on top of the bead. In all cases, the material is bleached locally by exposure to a sufficient intensity of light energy, e.g. a laser. Different exposure set-ups result in different types of codes being formed as given in the non-exhaustive list that follows:-

The most basic one is to use a highly focussed beam of laser energy to write the code directly on to the bead.

One may also use an interferometer system as an exposure source. These systems are conventionally used in the production of holograms.

Another method of producing codes is to pass a laser beam through two diffraction gratings, one fixed, the other rotating through small increments. The resultant diffraction pattern is allocated a code.

The following is a description by way of example only and with reference to the accompanying drawings of presently preferred embodiments of the invention. In the drawings:
Figure 1 is a cross-sectional view of a section of a sheet of polymeric material on a UV-release film;
Figure 2 is a plan view of an example of a coded particle;
Figure 3 is a cross-sectional view of a section of a delineated sheet of polymeric material on a UV-release film;
Figure 4 is a cross-sectional view of a section of a delineated sheet of polymeric material on a UV-release film on the bottom layer of a conventional microtitre plate;
Figure 5 is a plan view of a conventional microtitre plate incorporating the delineated sheet of polymeric material on a UV-release film;
Figure 6 is a side view of part of the conventional microtitre plate depicted in Figure 5;
Figure 7 is a schematic representation of the side view of the conventional microtitre plate depicted in Figures 5 and 6, together with means to remove the beads from the microtitre plate; and
Figure 8 shows read outs from code reading apparatus.

The technique described below can create an easy-to-handle array of discrete particles (alternatively, referred to as beads) within a polymer material. Monomers such as nucleotides can be printed on the top surface of the beads using an ink-jet printer type system. The beads may be of any suitable shape. Preferably, the beads are designed to be thin, typically 25 µm, rectangular shapes with typical lengths of 250 µm and widths of 40 µm.

Once the monomers have been applied to the beads, individual groups of beads can be released and processed e.g. using flow cytometry. With rectangular beads, the long aspect ratio lends itself easily to good mixing within the flow cell, thereby promoting effective binding of the bases onto the original sequence.

Each bead may have features defined around its periphery to give it a unique code. The structural embodiment discussed below is designed to be compatible with current microtitre plates having 96-wells although the techniques mentioned are equally applicable to larger or smaller well sizes or numbers. At such dimensions, each 3.5 mm-square well could easily contain an array of 100 by 40 (or 4000) beads. The total number of beads defined within a commercially available 96-well structure would then be in the region of 384,000.

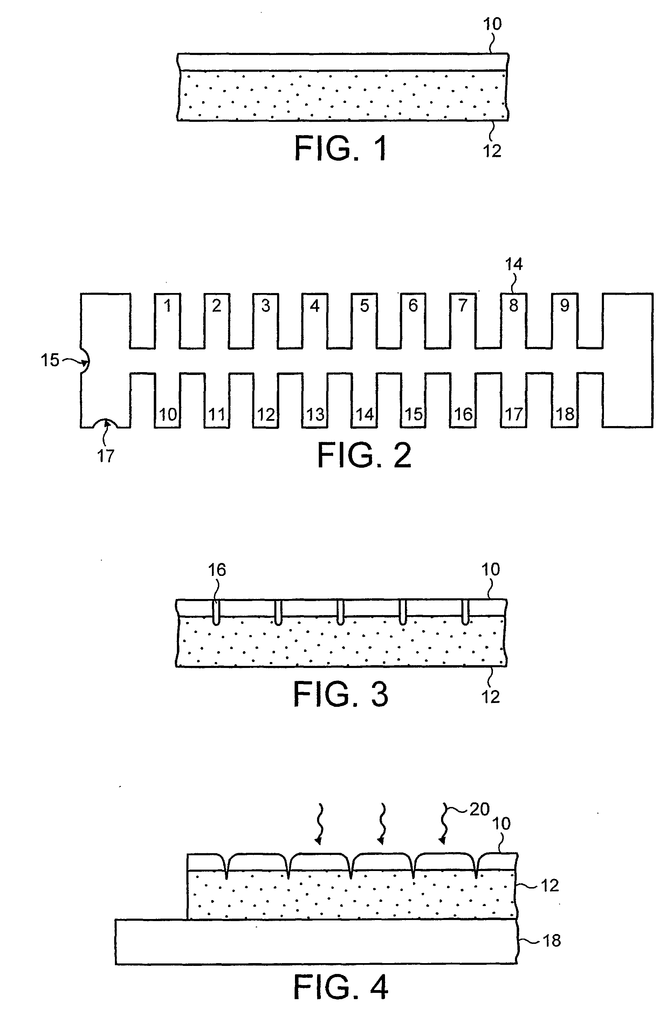

In the embodiment of the invention depicted by Figure 1, a sheet of plastics material 10, say 20 or 25 µm thick polyester or polycarbonate is placed upon another plastics sheet 12 having the specific property of being a UV-release material (e.g. 130 micron thick Furukawa UV tape-SP series). The two sheets are placed one on top of the other so as to exclude all air gaps.

This sandwiched structure is laid down on a flat surface vacuum chuck positioned on the x-y stage of a laser micro-machining system. Preferably, the laser system is a carbon dioxide laser system with a galvanometer scan head.

Typical galvanometer scanning fields are of the order of 50mm x 50mm with typically 500 features fabricated per second. Current systems have 4 to 5 bit coding systems. This concept permits the use of, for example, an 18 bit coding system through the creation of 18 "elements" 14 that can be turned on or off as required (Figure 2). An element width of 10 µm and an inter-element spacing of 10 microns is considered here. If all the elements are defined on the same side, the total length of a bead would be just under 500 µm which is considered longer than optimal. This length can be reduced to 250 µm if elements are defined on both sides. The reader would then need information relating to the reading sense of the bead, e.g. inaccurate reading of the code could result when the bead flips over etc. However, a technique is devised here whereby the addition of two further features 15, 17 on the bead caters for all combinations of reading sense.

Considering a pitch of 20 µm and 9 elements on each side, the length of the bead is now about 250 µm which is an acceptable length. An example of an 18-bit bead is shown in Figure 2.

The peak power of the laser is adjusted so that the plastics material 10 is cut at 16 all the way through but the UV sensitive tape 12 is just "nicked" by a few µm and is for all intents and purposes quite intact. Figure 3 shows that the integrity of the UV-release layer is substantially unaffected. This is preferred for all embodiments.

The machined sandwich is taken off the vacuum chuck and placed onto the bottom plate 18 of a conventional 96-well microtitre plate 24 (Figure 4) to provide about 4000 beads per well. Generally, there are plates that are fabricated by injection moulding in one piece and others that are fabricated in two parts with flat baseplate being ultrasonically welded to a perforated upper plate 26. In the present embodiment, nucleotides or oligonucleotides 20 are applied to the surface of the particles retained on the baseplate prior to the attachment of the upper plate.

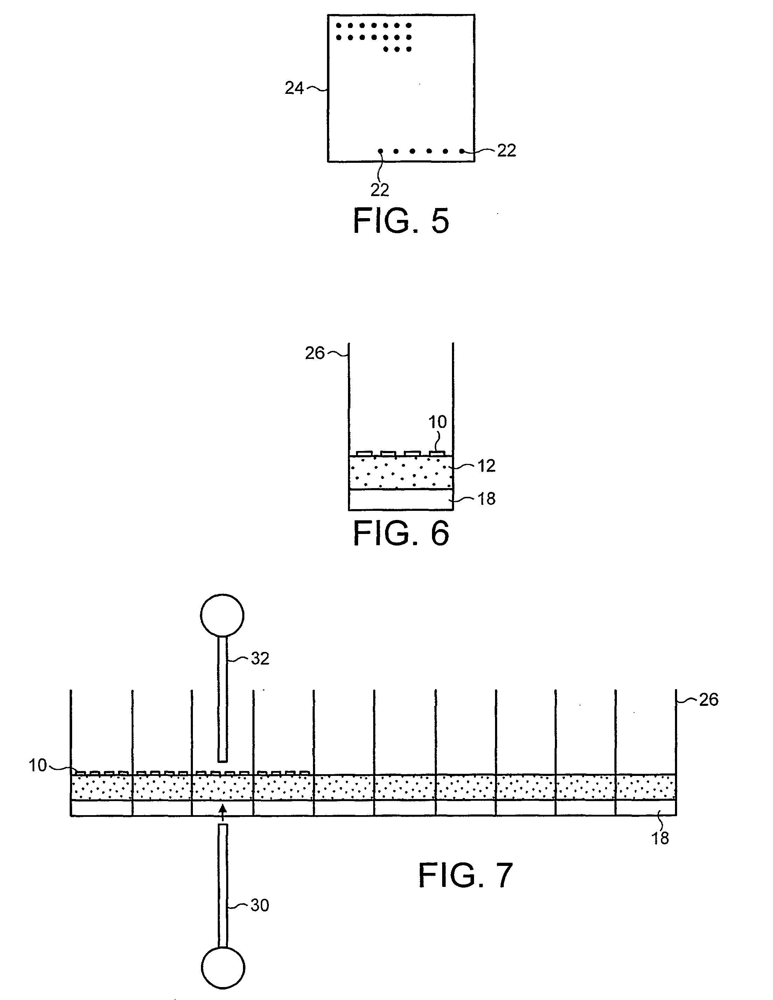

The upper plate of the microtitre plate is now placed on top of the baseplate, to enclose the laser machined plastics particle layer within the resulting wells 22. The resultant microtitre plate is depicted in Figures 5 and 6.

The next step is to remove a group of beads (exact number not important) in one operation and process them within the buffer solution of the flow system.

The first step is to locally destroy the adhesive property at the interface between the UV tape and a specific group of beads. Typical values for adhesive strengths of UV tape (currently available) are 2.5 N/25 mm before UV and 0.05 N/25 mm after UV. Typical UV dosages required to do this are of the order of 1000 mJ/cm². In this embodiment, a UV source 30 e.g. a pulsed laser beam delivering this magnitude type of energy per pulse, is located on a precision x-y stage and delivers its energy from below the microtitre plate. Once the requisite amount of energy has been delivered to a specific group of beads, the second challenge is to remove that specific group of beads.

The process of removing the beads must not damage the top surface containing the DNA bases. One way of doing this is to use a flat precision ground hollow needle or vacuum pick up 32 with inner diameters ranging between, e.g. 200 to 500 microns in diameter. The aperture could be blocked with a micro-porous membrane. The concept is to mount this needle on a precision x-y stage and point down within a well towards the cluster of 4000 beads. The removal procedure is shown in Figure 7.

If desired the substrate may be porous and may act as a filter during the use of the particles. Thus, for instance, the plastics layer for forming the particles may be coated over a sacrificial plastics layer on the surface of a porous substrate such as cellulose acetate nylon or polyether sulphone. After delineation of the beads and the application of chemical library members to the particles, a perforated plate may be affixed to form a microtitre plate. After or before assay reagents have been added to the particles, they may be released within the plate wells. After each addition of liquid in these processes, waste liquid may be withdrawn through the filter material. In particular, if the sacrificial layer is destroyed by solvent addition to liberate the particles in the wells, the waste solvent may be sucked out via the filter/substrate so that the particles are retained in their wells.

The present invention results in the fabrication of beads that have spatially defined machine-readable codes. There may be one or several beads bearing each unique code. Current silicon based systems have severe drawbacks that include low signal to noise ratio and poor diffusion during mixing. By using the present invention, results obtained from such a large numbers of beads within a well would lead to a greater degree of confidence in sequencing. Up to the total of 4000 beads within a well can be passed into the flow system to ensure good mixing.

Optionally, the desired surface finish could be produced by microetching or electropolishing processes. The functional layers may be electrodeposited and/or passivation applied.

Biolayers could be "patterned" directly onto polymer sheets by ink-jet printing. Oligomers could be built up by direct ink-jet printing of the monomers, thus reducing reagent waste and the problems associated with bead-handling. This process is particularly applicable to the fabrication of oligonucleotides.

An alternative fabrication method is now described for producing polymer based microparticles.

Preferably, in this method a silicon wafer is used as a substrate for the ensuing steps, although it will be understood by persons skilled in the art that any flat substrate could be used including porous substrates as describe above. The silicon wafer is cleaned and baked and then a photoresist of thickness approximately 3 µm that acts as a sacrificial layer is spun on to the surface of the substrate. A typical example of a suitable photoresist for this step is SPOLR30B, available from MicroChem Corporation of Massachusetts.

This sub-assembly is then baked prior to the application of a further photoresist layer by spinning. The second photoresist layer is approximately 20 µm in thickness and is a chemically amplified negative photoresist such as SU8-25, also available from MicroChem Corporation as above. This is then subjected to a pre-exposure bake in accordance with the manufacturer's instructions. Then an etched chrome-on-glass mask is positioned over the SU8 layer which is then exposed using a UV exposure tool or similar excitation apparatus. A post-exposure bake is conducted, again in accordance with the manufacturer's instructions and the exposed material is then developed using an appropriate developer to leave an array of patent or profiled microparticles on the substrate wafer.

As before, the microparticles may be functionalised prior to or subsequent to release from the wafer. Release is effected using diluted developer which dissolves the SPLOR30B layer.

Using the techniques outlined above, microparticles having a length in the order of 50 to 200 µm can be obtained. Typical microparticle dimensions are as follows:

| | |
|---|---|
| length | <100 µm |
| width | 30 µm |
| thickness | 20 µm |

For use in a chemical library, functionalisation of the microparticles is necessary to ensure that they are receptive to the chemistries or biochemistries which they are expected to undergo in downstream processing. Functionalisation can be by any suitable chemical means or gas means such as plasma etching, effective impart a desired chemical group to the microparticles surface for attachment of analyte or other precursor species.

For example, the microparticles described above may be functionalised to enable attachment of DNA, more particularly an oligonucleotide related to a DNA which it is desired to detect. In the first step of functionalisation, the micro-particles are silanated with HMDS (Hexa Methyl disilazane) followed by an organosilane such as N-2-aminoethyl-3-aminopropyl-trimethoxysilane, which forms a self-assembled film on the hydroxylated surfaces of the microparticles. Because unmodified oligonucleotides cannot be coupled directly to the silanol groups, the surface may be further functionalised with NHS-biotin which is an N-hydroxy succinimide ester-biotin complex. This attaches to the surface to the amino group which is presented by the silane film. The biotin molecule is then reacted with streptavidin, a protein. The streptavidin is then used to bind biotinylated DNA, forming a strong non-covalent interaction. The interaction is sufficiently strong to withstand the stringent washing required in later steps to minimise nonspecific hybridisation.

More specifically, silane deposition may be carried out by rinsing the beads in HMDS and curing for 30 minutes at 50°C. 2% TMS (N-2-aminoethyl-3-aminopropyl-trimethoxysilane) in dry acetone at room temperature is added for about 2 minutes. The beads are rinsed in dry acetone and dried.

In the step of functionalisation with biotin, the particles are immersed in 1 mg NHS-biotin in 250 µl dimethyl sulphoxide (DMSO) and gently agitated. After four hours, the particles are washed twice in DMSO followed by phosphate buffered saline.

After following the above procedure, the binding of the chemistries was assessed via the attachment of a FITC-streptavidin conjugate. A 100 µg/ml solution of streptavidin was resuspended in phosphate buffered saline having 0.5% of added Tween-20. Tween-20 is a surfactant. The streptavidin solution was incubated with the particles for two hours. Non-specifically bound streptavidin was then removed by agitating the particles for a further two hours in phosphate buffered saline with 0.5% Tween-20 added (PBST).

For the hybridisation assay, streptavidin was bound to the biotinylated surface. As in the fluorescent streptavidin assay described above, 100 µg/ml of streptavidin solution in 0.05% PBST was incubated with the particles for two hours at room temperature with agitation. This was followed by a two hour wash with PBST to remove non-specifically bound streptavidin.

An alternative method of attaching an amino-modified oligonucleotide is to use a homo-bifunctional cross-linker such as cyanuric chloride. These methods only serve as examples and there are other methods of achieving the attachment of molecules to the particles.

Following functionalisation of the particles with NHS-biotin and streptavidin, biotinylated DNA was attached. Two oligonucleotide sets were prepared, each set being a perfect match for the other. The oligonucleotide sets were 12 nucleotides in length. One set contained a biotinylated oligonucleotide which was anchored to the particle, whilst the other set containing the complementary oligonucleotides was labelled with fluorescein. The two sets were then mixed together in solution conditions suitable for hybridisation to test the viability of the system.

More specifically, the biotinylated oligonucleotides of one set were incubated with the particles at a concentration of 100 pM in 10 mM tris HC1, 1 mM EDTA, and 2M NaCl for 20 minutes at 30°C. This was followed by two wash steps, one in the tris buffer used for binding, followed by a wash with deionised water.

The other set of oligonucleotides, bearing the fluorescent label, was incubated with the particle-bound oligonucleotides in 50 mM tris, 18 mM EDTA and 0.1% Triton at PH 8.5 for 30 minutes at a temperature of 29°C. This was optimal for hybridisation of the oligonucleotide sets.

The particles were washed twice to remove any unbound DNA and to reduce the background fluorescence. The particles were visualised under a fluorescence microscope and fluorescence was detected using the set up described below to enable the presence of the bound DNA to be determined. The presence of fluorescence on the surface of the particles indicates that hybridisation had taken place confirms the viability of this approach.

Fluorescence images of the microparticles were obtained with a microscope, a 25 Mw 488 nm argon ion laser and CCD camera. The laser beam was spread by a 50 cm focal length lens and coupled into the epi-illumination system of the microscope with adjustable mirrors. The eye pieces were removed for safety and replaced by Cohu integrating CCD camera, with a 7-layer 550 nm band-pass interference filter in the path to remove the 488 nm main beam. The camera was connected to a Scion LG-3 Nubus frame grabber in a Macintosh Quadra 800 computer, which includes facilities for controlling the integration features of the camera. The particle handling and detection system uses the microscope to image a flow cell. A flow cytometer was modified to handle the beads and the beads were flowed through the system at approximately 1 metre per second. Although any illumination source with a spot size smaller than the smallest feature on the beads may be used, the beam of an Argon Ion laser (488 nm) was used in this instance. The forward and side scattered signals from the beads were detected using a photodiode/photomultiplier arrangement.

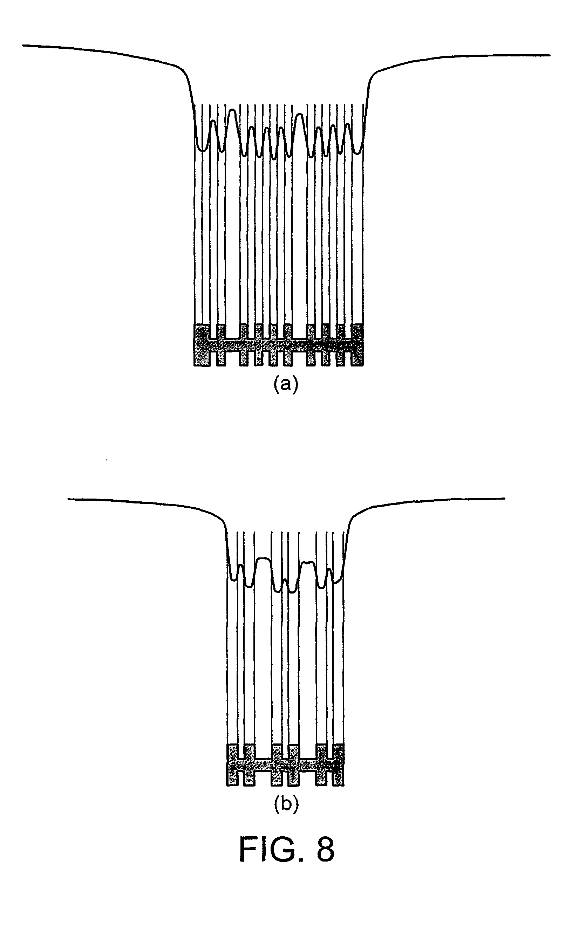

Referring now to Figure 8, views (a) and (b) show output traces obtained form two differently-coded particles. These are absorption traces, so that troughs in the trace coincide with protuberances on the surface of the microparticle.

In a modification of the microparticles described above, the particles are produced bearing a NiCr or other reflectance coating. If microparticles having the reflectance coating were to be detected using the detection system described here, a reflectance pattern could be traced instead of an absorption pattern. In the reflectance pattern, crests in the trace coincide with protuberances on the microparticle surface, whilst troughs in the trace correspond to hollows in the microparticle surface.

A suitable photo-lithographic mask for use in the above process is separated into a multitude of regions each containing a multitude of codes. Each bead pattern consists of 14 bits and 7 µm features. The length of a typical bead is therefore around 98 µm. Although 14 bits lead to a total code space of 16384 codes, there are a number of enhancement features that bring this figure down to a more reduced number of codes. Although one ends up with a reduced code space, clear benefits are obtained.

The following three enhancements confer clear benefits in the area of reduced possibility of errors in detection:
- The maximum number of consecutive DC bits has been selected to be four, this brings the original 16384 code space down to 11072.
- A parity constraint is used. This means that one can change any one of the bits to its complement and the result is not a valid code. This sets constraints such as either an even or odd number or O's or 1's in every valid code. We have chosen 1 bit even parity so that the number of 1's is always even. This has the effect of bringing the 11072 code space down to 5536.
- Removing reversals to impose a reading sense. For any given code in the set, the reverse code is omitted, thus if a code reads 321 then it can only be 321 because 123 has been deleted from the code space. These removals bring the 5536 code space down to 2724.

The following confer clear benefits in the area of handling and error detection:
- Redundancy - the number of duplicate codes. The layout of the beads may be designed such that the 2724 separate and sequential codes are bounded within rectangles some 5 mm x 20 mm in dimension. This dimension has been chosen with handling in mind - after bead fabrication and wafer dicing, the rectangle can be placed within a 1.5 ml tube (e.g. Eppendorf or similar). The introduction of this feature means that a complete set of beads can now be contained within a small volume amenable to centrifuging. It is possible to fit 13,620 beads into this 5 mm x 20 mm rectangle and thus provide a redundancy figure of 5 per code.
- The code also generates 88 'palindromes', i.e. the code reads the same whether you read it from left-to-right or right-to-left. An example of this is 00001000010000. The 88 palindromes have been separated from the code space and used for test and error checking purposes.

Although the invention has been described above with reference to particular embodiments, it will be understood by persons skilled in the art that variations and modifications are possible without departing from the scope of the claims which follow.

## Claims

1. A method of fabricating coded particles comprising:
providing a sheet of polymeric material on a substrate;
delineating the sheet into a plurality of particles without destroying the integrity of the substrate;
machine-readably encoding the particles; and
removing the particles from the substrate.

2. A method as claimed in Claim 1, wherein the particles are morphologically encoded during the delineation.

3. A method as claimed in Claim 1, wherein the particles are encoded after delineation but before removal of the substrate.

4. A method as claimed in any one of the preceding Claims, wherein adhesion between said sheet and the substrate is produced by a radiation-sensitive sacrificial layer whose properties are modified to reduce the strength of the adhesion to release the particles.

5. A method as claimed in any one of the preceding claims, wherein the particles are delineated by laser machining.

6. A method as claimed in any one of the preceding claims, wherein the encoding comprises the formation of a plurality of switchable elements around the periphery of each particle.

7. A method as claimed in any one of the preceding claims, wherein each particle is formed with at least one reading sense identifier.

8. A method as claimed in any one of the preceding claims, wherein the machine readable code is formed by bleaching the fluorescence of a constituent of each particle.

9. A method as claimed in any one of the preceding claims, wherein defined chemical or biological library members are supported on respective encoded particles prior to removal of the substrate.

10. A method as claimed in any one of Claims 1 to 9, wherein defined chemical or biological library members are applied to or synthesises on said particles in a well of a micro titre plate.

11. A method as claimed in any one of Claims 1 to 8, wherein a defined chemical or biological library member is applied to or synthesised on each particle after release of said particle from said substrate.

12. A method as claimed in any one of Claims 9 to 11, wherein at least two defined chemical library members are provided on each particle, each said member occupying its own respective space on said particle separate from the space occupied by the or each other member thereon.

## Patentansprüche

1. Verfahren zur Herstellung kodierter Partikel, umfassend die folgenden Schritte: Bereitstellen einer Polymermaterialschicht auf einem Substrat; Unterteilen der Schicht in eine Mehrzahl von Partikeln, ohne die Integrität des Substrats zu zerstören; maschinenlesbares Kodieren der Partikel; und Entfernen der Partikel von dem Substrat.

2. Verfahren nach Anspruch 1, wobei die Partikel während der Unterteilung morphologisch kodiert werden.

3. Verfahren nach Anspruch 1, wobei die Partikel nach dem Unterteilen, aber vor dem Entfernen von dem Substrat kodiert werden.

4. Verfahren nach einem der vorherigen Ansprüche, wobei die Adhäsion zwischen der genannten Schicht und dem Substrat durch eine strahlenempfindliche Opferlage erzeugt wird, deren Eigenschaften zur Verringerung der Stärke der Adhäsion modifiziert werden, um die Partikel freizugeben.

5. Verfahren nach einem der vorherigen Ansprüche, wobei die Partikel durch Laserbearbeitung unterteilt werden.

6. Verfahren nach einem der vorherigen Ansprüche, wobei das Kodieren die Bildung einer Mehrzahl von schaltbaren Elementen um die Peripherie jedes Partikels umfasst.

7. Verfahren nach einem der vorherigen Ansprüche, wobei jeder Partikel mit wenigstens einem Lesesinnidentifizierer gebildet wird.

8. Verfahren nach einem der vorherigen Ansprüche, wobei der maschinenlesbare Kode durch Bleichen der Fluoreszenz eines Bestandteils jedes Partikels gebildet wird.

9. Verfahren nach einem der vorherigen Ansprüche, wobei definierte chemische oder biologische Bibliothekenmitglieder auf jeweiligen kodierten Partikeln getragen werden, bevor das Substrat entfernt wird.

10. Verfahren nach einem der Ansprüche 1 bis 9, wobei definierte chemische oder biologische Bibliothekenmitglieder auf die genannten Partikel in einem Well einer Mikrotiterplatte aufgebracht oder darauf synthetisiert werden.

11. Verfahren nach einem der Ansprüche 1 bis 8, wobei ein definiertes chemisches oder biologisches Bibliothekenmitglied auf jeden Partikel aufgebracht oder darauf synthetisiert wird, nachdem der genannte Partikel von dem genannten Substrat freigegeben wurde.

12. Verfahren nach einem der Ansprüche 9 bis 11, wobei wenigstens zwei definierte chemische Bibliothekenmitglieder auf jedem Partikel vorgesehen werden, wobei jedes der genannten Mitglieder seinen eigenen jeweiligen Raum auf dem genannten Partikel einnimmt, der von dem Raum getrennt ist, der von dem oder jedem anderen Mitglied darauf eingenommen wird.

## Revendications

1. Procédé de fabrication de particules codées comprenant :
fournir une feuille de matière polymère sur un substrat;
tracer une pluralité de particules sur la feuille sans détruire l'intégrité du substrat;
coder les particules d'une manière lisible sur machine; et
enlever les particules du substrat.

2. Procédé tel que revendiqué dans la revendication 1, dans lequel les particules sont codées morphologiquement durant le traçage.

3. Procédé tel que revendiqué dans la revendication 1, dans lequel les particules sont codées après le traçage mais avant leur enlèvement du substrat.

4. Procédé tel que revendiqué dans l'une quelconque des revendications précédentes, dans lequel l'adhérence entre ladite feuille et le substrat est produite par une couche sacrificielle sensible au rayonnement dont les propriétés sont modifiées pour réduire la force d'adhésion afin de dégager les particules.

5. Procédé tel que revendiqué dans l'une quelconque des revendications précédentes, dans lequel les particules sont tracées par usinage au laser.

6. Procédé tel que revendiqué dans l'une quelconque des revendications précédentes, dans lequel le codage comprend la formation d'une pluralité d'éléments commutables autour de la périphérie de chaque particule.

7. Procédé tel que revendiqué dans l'une quelconque des revendications précédentes, dans lequel chaque particule est formée avec au moins un identificateur de sens de lecture.

8. Procédé tel que revendiqué dans l'une quelconque des revendications précédentes, dans lequel le code lisible sur machine est formé en blanchissant la fluorescence d'un constituant de chaque particule.

9. Procédé tel que revendiqué dans l'une quelconque des revendications précédentes, dans lequel des membres définis d'une banque chimique ou biologique sont supportés sur des particules codées respectives préalablement à leur enlèvement du substrat.

10. Procédé tel que revendiqué dans l'une quelconque des revendications 1 à 9, dans lequel des membres définis d'une banque chimique ou biologique sont appliqués à ou synthétisés sur lesdites particules dans un puits d'une plaque de microtitrage.

11. Procédé tel que revendiqué dans l'une quelconque des revendications 1 à 8, dans lequel un membre défini d'une banque chimique ou biologique est appliqué à ou synthétisé sur chaque particule après le dégagement de ladite particule dudit substrat.

12. Procédé tel que revendiqué dans l'une quelconque des revendications 9 à 11, dans lequel au moins deux membres définis d'une banque chimique, sont fournis sur chaque particule, chaque dit membre occupant son propre espace respectif sur ladite particule, séparé de l'espace occupé par le ou chaque autre membre sur celle-ci.
